# EUROPEAN PATENT SPECIFICATION

(11) **EP 1 515 598 B1**
(45) Date of publication and mention of the grant of the patent: **10.09.2008**
(21) Application number: 04445001.3
(22) Date of filing: 02.01.2004
(51) Int. Cl.: H05K 9/00

(54) **Shield for circuit board and method of manufacturing same**
Abschirmvorrichtung für eine Leiterplatte und deren Herstellungsverfahren
Blindage pour une plaque de circuit et sa fabrication

(30) Priority: 12.09.2003 EP 03077870
(43) Date of publication of application: 16.03.2005
(73) Proprietor: Sony Ericsson Mobile Communications AB, 221 88 Lund (SE)
(72) Inventor: Olsson, Mats, 21431 Malmö (SE)
(74) Representative: Akerman, Marten Lennart

(56) References cited:
- WO-A-02/24431
- WO-A-03/032703
- DE-C- 19 945 427
- PATENT ABSTRACTS OF JAPAN vol. 1999, no. 12, 29 October 1999 (1999-10-29) & JP 11 177270 A (MITSUMI ELECTRIC CO LTD), 2 July 1999 (1999-07-02)

## Description

### Field of the invention

The present invention relates to a shield for circuit boards, and more particularly a shield, suitably manufactured from a one piece metal cover in which shielding portions have been formed by shaping walls depending from a roof of the cover. The invention also relates to the corresponding manufacturing method.

### State of the art

Some components on a printed circuit board (PCB) need to be protected or covered with some kind of metal shield. Today it is common to use metal cans soldered to the circuit board. These cans may have lids that are snapped on for repair reasons. If the need for rework of the components is limited, solid cans without lids can be used. Other technologies, like metallized plastic cans with dispensed gaskets are also available and have previously been used.

One problem is that all shield cans consume space on the circuit board. They also add extra thickness to the complete PCB solution as they act as a lid on top of the components. Especially soldered cans with removable lids tend to grow in height as they consist of two parts, walls and lid, that are overlapping each other resulting in double material thickness.

Shield cans without lids (one piece) are often deep-drawn out of one piece of material. The internal shielding walls are then formed directly in the sheet metal. Due to the manufacturing process (need for radiuses in the comers, draft angles, poor tolerances, etc) there is considerable waste of PCB area. One-piece cans can also have internal walls that are made of a separate piece of material and joined together with the can by spot welding. This method wastes less PCB area but is on the other hand more complex and expensive.

In most situations there is a need for several separate shield cans. When two shield cans are mounted beside each other, there is quite a tolerance chain to take into account. Because of this the solder traces on the PCB must be made wide resulting in poor usage of the PCB area.

For small circuit boards with limited need for rework of components, like Blue Tooth or RF-modules, it is possible to permanently solder the can to the PCB. Such a shield does not need a removable lid and can thus be made in a simpler way (one piece).

DE19945427 disclose a screening device for screening of electromagnetic radiation at and from electronic components has a first screening chamber and at least a second screening chamber. The screening device has an integral design, wherein the at least second chamber forms an inner chamber which lies within the first screening chamber, and the inner chamber is more specfically is additionally fixed to the first screening chamber via a crimp-connection

WO02/24431 discloses multi-layered moldings and methods for manufacturing multi-layered moldings. A metallized layer can be deposited on at least one side of a substrate. The substrate can be shaped and then the metal layer can be deposited onto the shaped substrate.

### Summary of the invention

The present invention solves among other things this problem by replacing individual shield cans with a cover, covering the circuit board and forming a shield by shaping shielding walls to be depending from the roof of the cover and located relative to components to be shielded.

In a first aspect, the present invention provides a shield for a circuit board comprising at least one shield portion shaped from a cover adapted to cover at least part of the circuit board.

In a preferred embodiment, the cover has exterior walls and a roof, wherein the shield portion comprises an interior shielding wall shaped to depend from the roof.

A hole may be formed in the roof where the interior shielding wall is depending.

Suitably, the shielding wall is shaped by cutting and bending material from the roof.

Preferably, the cover is adapted to cover substantially the whole circuit board.

The cover may be made of metallized plastic or metal.

In a second aspect, the present invention provides a method of forming a shield for a circuit board, comprising the steps of shaping at least one shield portion from a cover adapted to cover at least part of the circuit board.

In a preferred embodiment, the cover has exterior walls and a roof, wherein the shield portion is shaped by forming an interior shielding wall depending from the roof.

A hole may be formed in the roof where the interior shielding wall is depending.

The shielding wall may be shaped by cutting and bending material from the roof.

The cover is made of metallized plastic or metal.

The cover may be soldered to the board.

### Brief description of the drawings

The invention will be described in detail below with reference to the accompanying drawings, in which:
Fig. 1 is a perspective view from above of a shield according to the present invention mounted on a circuit board;
Fig. 2 is a perspective view from below of the shield; and
Fig 3 is a detail view of some shield walls of Fig. 2.

### Detailed description of preferred embodiments

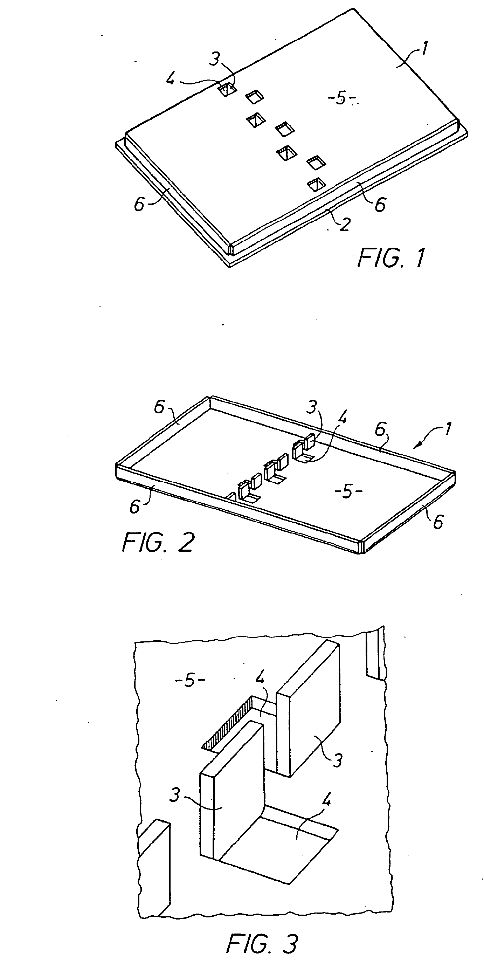

In Fig. 1 there is shown an embodiment of a shield in accordance with the present invention. The shield is made from a one piece cover 1 mounted on a printed circuit board 2, e.g. in a mobile telephone or other electronic equipment. In the embodiment shown, the cover 1 covers substantially the whole circuit board 2. This is the most space efficient solution since the walls 6 of the cover 1 require space on the circuit board for attachment, e.g. by soldering or gluing. It is also possible that the cover is only covering part of the circuit board, the cover in this case only covering some components and the rest of the circuit board being unshielded or carrying other shields.

The shields are formed by shielding portions 3 depending from the roof 5, in Figs. 2 and 3 shown as tabs 3 upstanding from the inside of the roof. The spacing of the tabs 3 are calculated to get a proper shielding performance. The tabs will be located in correct positions relative to the components in question. A component may be totally surrounded by shielding walls by placing the tabs in a square around the component.

The internal shielding walls 3 can be made by cutting out sections from the roof 5 of the cover and bending the section down to form a wall. This will leave openings in the roof, in the embodiment shown as square holes 4. These holes do not pose a problem, but will allow air to circulate inside the cover 1.

The manufacturing method is especially suitable when using a cover made of a one-piece metal sheet. However, by adapting the method other materials are also possible, provided that the materials have suitable shielding and forming characteristics. The shield may be manufactured in metallized plastics by injection moulding a plastic shield to a cover having the desired shape and metallizing the cover.

The cover may be removably attached to the circuit board 2, or permanently fixed by soldering, fusing or gluing etc.

The present invention has several advantages over the prior art individual shielding cans. The shield may be manufactured by means of a simple and cheap metal stamping process. The shield saves height because there is only one layer of material. The shield provides a very space efficient design of the internal shielding walls, resulting in less waste of PCB area.

The scope of the invention is only limited by the claims below.

## Claims

1. A shield for a circuit board (2), comprising at least one shield portion (3) shaped from a cover (1) adapted to cover at least part of the circuit board (2), the cover (1) having exterior walls (6) and a roof (5), wherein the shield portion comprises an interior shielding wall (3) shaped to depend from the roof (5),
**characterised in that** a hole (4) is formed in the roof (5) where the interior shielding wall (3) is depending.

2. A shield according to claim 1, **characterised in that** the cover (1) is adapted to cover substantially the whole circuit board (2).

3. A shield according to claim 1 or 2, **characterised in that** the shielding wall (3) is shaped by cutting and bending material from the roof (5).

4. A shield according to any one of claims 1 to 2, **characterised in that** the cover (1) is made of metallized plastic.

5. A shield according to any one of claims 1 to 3, **characterised in that** the cover (1) is made of metal.

6. A method of forming a shield for a circuit board (2), comprising the steps of:
shaping at least one shield portion (3) from a cover (1) having exterior walls (6) and a roof (5), and adapted to cover at least part of the circuit board (2); shaping the shield portion by forming an interior shielding wall (3) depending from the roof (5), **characterised in that** a hole (4) is formed in the roof (5) where the interior shielding wall (3) is depending.

7. A method according to claim 6, **characterised in that** the shielding wall (3) is shaped by cutting and bending material from the roof (5).

8. A method according to claim 6, **characterised in that** the cover (1) is made of metallized plastic.

9. A method according to claim 6 or 7, **characterised in that** the cover (1) is made of metal.

10. A method according to claim 9, **characterised in that** the cover (1) is soldered to the board (2).

## Patentansprüche

1. Abschirmung für eine Schaltungsplatte (2), die mindestens einen Abschirmungsabschnitt (3), der aus einem Deckel (1), der angepasst ist, um mindestens einen Teil der Schaltungsplatte (2) zu bedecken, geformt ist, aufweist, wobei der Deckel (1) äußere Wände (6) und eine Decke (5) hat, wobei der Abschirmungsabschnitt eine innere Abschirmwand (3) aufweist, die geformt ist, um von der Decke (5) herabzuhängen,
**dadurch gekennzeichnet,**
**dass** ein Loch (4) in der Decke (5) gebildet ist, wo die innere Abschirmwand (3) herabhängt.

2. Abschirmung nach Anspruch 1,
**dadurch gekennzeichnet,**
**dass** der Deckel (1) angepasst ist, um im Wesentlichen die ganze Schaltungsplatte (2) zu bedecken.

3. Abschirmung nach Anspruch 1 oder 2,
**dadurch gekennzeichnet,**
**dass** die Abschirmwand (3) durch Schneiden und Biegen eines Materials von der Decke (5) geformt ist.

4. Abschirmung nach einem der Ansprüche 1 bis 2,
**dadurch gekennzeichnet,**
**dass** der Deckel (1) aus metallisiertem Kunststoff hergestellt ist.

5. Abschirmung nach einem der Ansprüche 1 bis 3,
**dadurch gekennzeichnet,**
**dass** der Deckel (1) aus Metall hergestellt ist.

6. Verfahren zum Bilden einer Abschirmung für eine Schaltungsplatte (2) mit folgenden Schritten:
Formen mindestens eines Abschirmungsabschnitts (3) aus einem Deckel (1), der äußere Wände (6) und eine Decke (5) hat und angepasst ist, um mindestens einen Teil der Schaltungsplatte (2) zu bedecken;
Formen des Abschirmungsabschnitts durch Bilden einer inneren Abschirmwand (3), die von der Decke (5) herabhängt,
**dadurch gekennzeichnet,**
**dass** ein Loch (4) in der Decke (5) gebildet wird, wo die innere Abschirmwand (3) herabhängt.

7. Verfahren nach Anspruch 6,
**dadurch gekennzeichnet,**
**dass** die Abschirmwand (3) durch Schneiden und Biegen eines Materials von der Decke (5) geformt wird.

8. Verfahren nach Anspruch 6,
**dadurch gekennzeichnet,**
**dass** der Deckel (1) aus metallisiertem Kunststoff hergestellt wird.

9. Verfahren nach Anspruch 6 oder 7,
**dadurch gekennzeichnet,**
**dass** der Deckel (1) aus Metall hergestellt wird.

10. Verfahren nach Anspruch 9,
**dadurch gekennzeichnet,**
**dass** der Deckel (1) an die Platte (2) gelötet wird.

## Revendications

1. Blindage pour une carte de circuits (2), comprenant au moins une portion de blindage (3), formée à partir d'un couvercle (1) conçu pour recouvrir au moins une partie de la carte de circuits (2), le couvercle (1) ayant des parois extérieures (6) et une couverture (5), dans lequel la portion de blindage comprend une paroi intérieure de blindage (3) dont la forme s'étend à partir de la couverture (5),
**caractérisé en ce qu'**un trou (4) est formé dans la couverture (5) à l'endroit d'où part la paroi intérieure de blindage (3).

2. Blindage selon la revendication 1, **caractérisé en ce que** le couvercle (1) est conçu pour recouvrir substantiellement toute la carte de circuits (2).

3. Blindage selon la revendication 1 ou 2, **caractérisé en ce que** la paroi de blindage (3) est formée par une découpe et un pliage de matériau issu de la couverture (5).

4. Blindage selon l'une quelconque des revendications 1 et 2, **caractérisé en ce que** le couvercle (1) est fabriqué en matière plastique métallisée.

5. Blindage selon l'une quelconque des revendications 1 à 3, **caractérisé en ce que** le couvercle (1) est fabriqué en métal.

6. Procédé de formage d'un blindage pour une carte de circuits (2), comprenant les étapes consistant à :
former au moins une portion de blindage (3) à partir d'un couvercle (1) ayant des parois extérieures (6) et une couverture (5) et conçu pour recouvrir au moins une partie de la carte de circuits (2) ;
former la portion de blindage en formant une paroi intérieure de blindage (3) à partir de la couverture (5) ;
**caractérisé en ce qu'**un trou (4) est formé dans la couverture (5) à l'endroit d'où part la paroi intérieure de blindage (3).

7. Procédé selon la revendication 6, **caractérisé en ce que** la paroi de blindage (3) est formée par une découpe et un pliage de matériau issu de la couverture (5).

8. Procédé selon la revendication 6, **caractérisé en ce que** le couvercle (1) est fabriqué en matière plastique métallisée.

9. Procédé selon la revendication 6 ou 7, **caractérisé en ce que** le couvercle (1) est fabriqué en métal.

10. Procédé selon la revendication 9, **caractérisé en ce que** le couvercle (1) est soudé sur la carte (2).
